# EUROPEAN PATENT APPLICATION

(11) **EP 4 712 066 A1**
(43) Date of publication of application: **18.03.2026**
(21) Application number: 25195043.2
(22) Date of filing: 11.08.2025
(51) Int. Cl.: G09G 3/32

(54) **DISPLAY DEVICE**

(30) Priority: 13.09.2024 JP 2024158755
(71) Applicant: Alps Alpine Co., Ltd., Ota-ku, Tokyo 145-8501 (JP)
(72) Inventor: Kishida, Katsuhiko, Iwaki-City (JP)
(74) Representative: Schmitt-Nilson Schraud Waibel Wohlfrom Patentanwälte Partnerschaft mbB

(57) **Abstract**

A display device includes: a substrate; a daisy-chain wiring formed on the substrate; and a plurality of light-emitting devices connected in a daisy chain via the daisy-chain wiring.

## Description

The present disclosure relates to a display device in which a plurality of light-emitting elements or devices are arranged on a substrate, and particularly to a display device, in which a light-emitting diode (LED) device such as a micro-LED is mounted on a substrate.

In recent years, micro-LEDs that can directly display images from light-emitting diodes have been developed. The micro-LEDs are two-dimensionally arranged to correspond to each pixel. For example, the anode of each light-emitting diode is commonly connected to a data wiring, and the cathode is connected to a scan wiring to drive each light-emitting diode (e.g., PCT Japanese Translation Patent Publication No. 2021-504752).

The present disclosure relates to a display device according to the appended claims. Embodiments are disclosed in the dependent claims.

Particularly, a display device according to an aspect of the present disclosure includes a substrate, a daisy-chain wiring formed on the substrate, and a plurality of light-emitting devices connected in a daisy chain via the daisy-chain wiring.
FIG. 1 is a diagram illustrating an image of a transparent film LED display which can be cut to achieve a desired shape;
FIG. 2A is a diagram illustrating an example of a matrix wiring of a conventional LED display and an example of cutting an LED display into a desired shape;
FIG. 2B is a diagram illustrating the example of the matrix wiring of the conventional LED display and another example of cutting the LED display into a desired shape;
FIG. 3A is a diagram illustrating an overall configuration of a display device according to an embodiment of the present disclosure;
FIG. 3B is a diagram illustrating LED devices connected in a daisy chain according to an embodiment of the present disclosure;
FIG. 3C is a diagram illustrating a configuration of a terminal surface of the LED device according to an embodiment of the present disclosure;
FIG. 4 is a diagram illustrating an internal configuration of the LED device according to an embodiment of the present disclosure;
FIG. 5 is a schematic perspective view illustrating a configuration of an LED substrate according to a first embodiment of the present disclosure;
FIG. 6 is a schematic perspective view illustrating a configuration of an LED substrate according to a second embodiment of the present disclosure;
FIG. 7 is a schematic perspective view illustrating a configuration of an LED substrate according to a third embodiment of the present disclosure;
FIG. 8 is a plan view illustrating a configuration of an LED substrate according to a fourth embodiment of the present disclosure;
FIG. 9 is a schematic perspective view illustrating a configuration of an LED substrate according to a fifth embodiment of the present disclosure;
FIG. 10A is a plan view illustrating a configuration of the LED substrate according to the fifth embodiment of the present disclosure; and
FIG. 10B is a plan view illustrating another configuration of the LED substrate according to the fifth embodiment of the present disclosure.

In the market, there is a demand for transparent, flexible, and freeform LED displays in which LEDs are arranged in a matrix. Although LED displays made of a transparent film have been developed, there is an issue that these LED displays cannot be made to a desired shape.

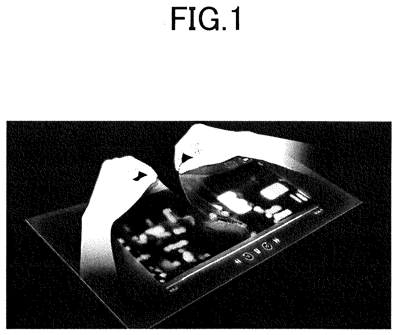

FIG. 1 is a diagram illustrating an image of an LED display made of transparent film which can be cut to achieve a desired shape. In order to change the shape and size of the LED display according to the application of the LED display, a user may cut the LED display with scissors or a cutter, or cut off a part of the LED display. In this case, an electric signal cannot be sent beyond the part where the LED display is cut, and thus, the LEDs beyond the cut point do not emit light. Accordingly, an area where an image cannot be displayed will be generated on the LED display.

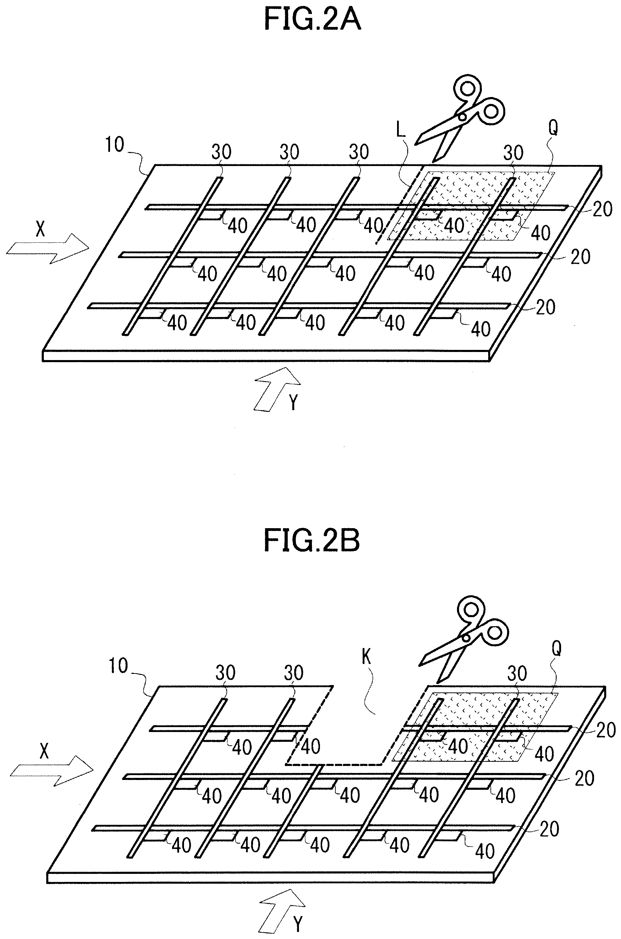

FIGS. 2A and 2B are schematic diagrams of a wiring of a passive drive type LED display. A data wiring 20 (e.g., column direction) and a scan wiring 30 (e.g., row direction) are formed in a matrix on a surface of a substrate 10, and LEDs 40 are mounted at intersections of the data wiring 20 and the scan wiring 30. When an energizing direction of the data wiring 20 is X and the energizing direction of the scan wiring 30 is Y, and when a user cuts the substrate 10 along a line L as illustrated in FIG. 2A or cuts out a region K that is a part of the substrate 10 as illustrated in FIG. 2B, an electric signal is not supplied to the area beyond the cut line or part, and a region Q where an image cannot be displayed is generated. Accordingly, display performance of the display device deteriorates.

An object of the present disclosure is to solve such conventional issues and to provide a display device which can be cut to achieve a desired shape as required by a user.

The present disclosure relates to a display device (display) in which a plurality of light-emitting devices are mounted on a substrate, and more particularly, to a display device which can be cut to achieve a desired shape as required by a user. The light-emitting device is not particularly limited, but includes, for example, microLEDs in a package. When the display device displays a color image, the light-emitting device includes R, G, and B microLEDs. The light-emitting device may also include active elements that are daisy-chained, receive control data from an adjacent light-emitting device, and control the light emission of the LEDs based on the control data. It should be noted that the drawings referred to in the following description include exaggerated representations to facilitate the understanding of the disclosure and do not represent the actual shape or scale of a product.

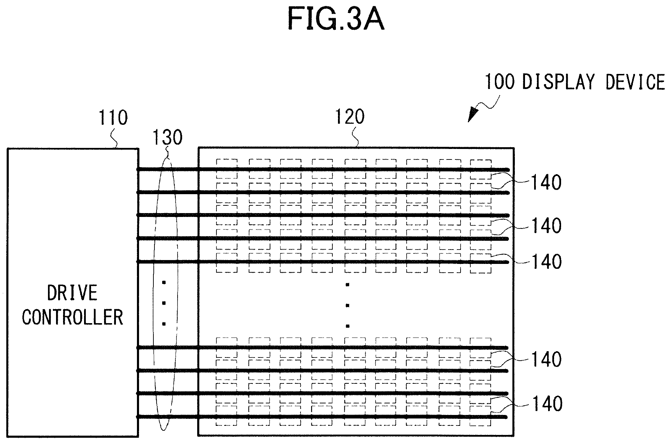

FIG. 3A is a block diagram illustrating an overall configuration of a display device according to an embodiment of the present disclosure. As illustrated in the diagram, a display device 100 includes a drive controller 110 (electronic circuitry) and an LED substrate 120. A plurality of daisy-chain wirings 130 are formed on the LED substrate 120, and one end of the daisy-chain wirings 130 is electrically connected to the drive controller 110. A plurality of LED devices 140 (electronic circuitry) connected through the daisy-chain wirings 130 are mounted on the LED substrate 120.

The planar shape of the LED substrate 120 is not particularly limited, but has, for example, a rectangular shape as illustrated in the diagram. The LED substrate 120 is made of a material that can be cut by a cutting device such as scissors or cutters, or has such a thickness, and includes a light-transmissive substrate such as glass, plastic, acrylic, or a film, or a semiconductor substrate such as silicon. Preferably, the LED substrate 120 is a transparent-film polyimide substrate.

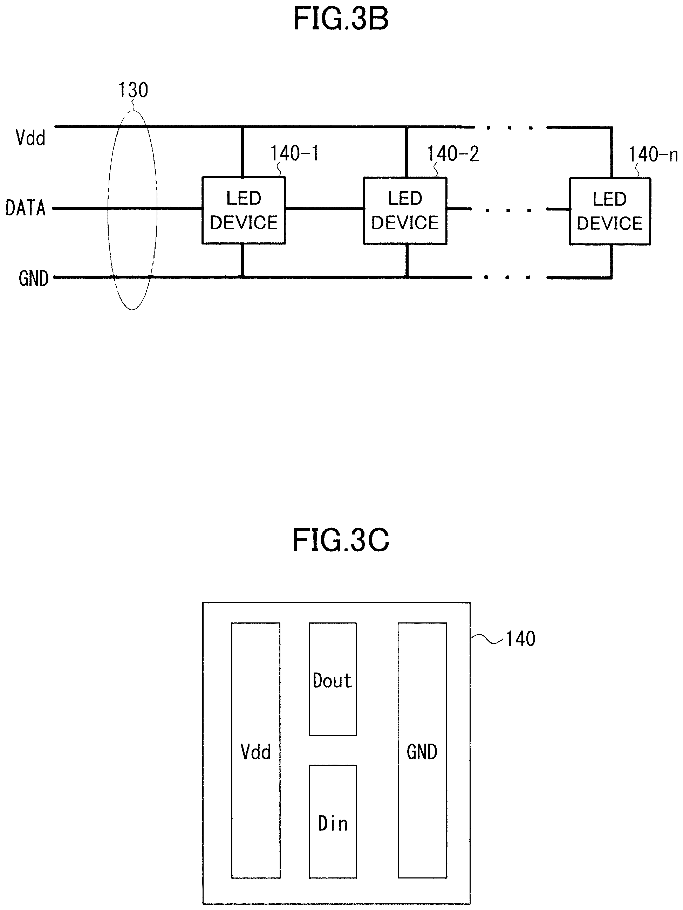

On a surface of the LED substrate 120, linear daisy-chain wirings 130 are formed along a longitudinal direction of the LED substrate 120. As illustrated in FIG. 3B, single daisy-chain wiring 130 includes a Vdd wiring, a GND wiring, and a DATA wiring configured to supply electric power. Here, for convenience, three of the Vdd wiring, GND wiring, and DATA wiring are integrally referred to as the daisy-chain wiring.

The daisy-chain wiring 130 is formed by patterning a single layer or a stack of metal materials, such as Au, Ag, Cu, AgMg, Al, and ITO, deposited on the LED substrate 120. A plurality of such daisy-chain wirings 130 are formed in a transverse direction of the LED substrate 120.

The drive controller 110 is electrically connected to the LED devices 140 via the daisy-chain wirings 130. FIG. 3B is a diagram illustrating an example of the daisy-chain connection of the LED devices 140, and FIG. 3C is a plan view illustrating a terminal surface of one LED device. One LED device 140 is formed to have, for example, a rectangular package, and a Vdd terminal, a Din terminal, a Dout terminal, and a GND terminal are formed on the terminal surface (for example, a bottom surface) of the package, as illustrated in FIG. 3C.

As illustrated in FIG. 3B, the Vdd and GND terminals of LED devices 140-1, 140-2, ..., 140-n (integrally referred to as the LED devices 140) are connected to the common Vdd and GND wires. A Din terminal of the leading LED device 140-1 is electrically connected to the drive controller 110 via the DATA wiring, a Dout terminal is electrically connected to the Din terminal of the adjacent LED device 140-2 via the DATA wiring, and the Dout terminal of the LED device 140-2 is electrically connected to the Din terminal of the adjacent LED device 140-3 via the DATA wiring. In other words, each of the LED devices 140-1, 140-2, ..., 140-n is serially connected to each other in series via the DATA wiring. Each terminal of the LED device 140 is electrically connected to the Vdd, GND, and DATA wires by using, for example, solder or conductive adhesive.

Thus, the plurality of LED devices 140 connected in the daisy chain with a constant pitch in both the column and row directions are arranged in a matrix on the LED substrate 120. As will be described in the following, the drive controller 110 applies control data to each of the LED devices connected in the daisy chain via the DATA wiring, and each of the LED devices controls light emission of an LED element based on the received control data.

In FIG. 3A, the Vdd and GND wires are extended from the drive controller 110, but this is an example, and the Vdd and GND wires may be extended on the LED substrate 120 from a power supplier separated from the drive controller 110.

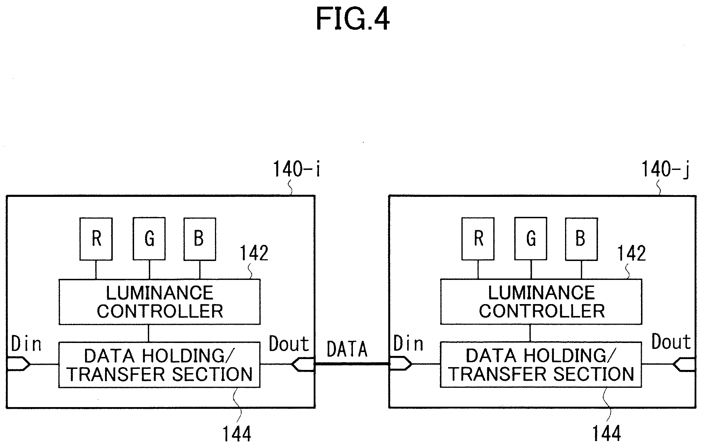

FIG. 4 is a diagram illustrating an internal configuration of the LED device and an example of connecting adjacent LED devices. One LED device 140-i includes R, G, and B LED elements, a luminance controller 142 (electronic circuitry), and a data holding/transfer section 144 in a package. When displaying a color image, one pixel (picture element) is composed of three sub-pixels R (red), G (green), and B (blue).

The data holding/transfer section 144 is connected to the Din terminal and the Dout terminal, and when the control data input from the Din terminal includes control data addressed to the local data holding/transfer section 144, the data holding/transfer section 144 extracts the control data addressed to itself and stores it in a memory such as a register. In contrast to this, when the control data addressed to the local data holding/transfer section 144 is not included, the data holding/transfer section 144 outputs the control data from the Dout terminal and transfers the control data to the next LED device 140-j. The luminance controller 142 controls the light emission of R, G, and B based on the control data held by the data holding/transfer section 144.

A transfer method of the control data in the LED devices connected to the daisy chain is not particularly limited, but is performed as follows, for example. Each of the LED devices 140 is assigned a unique address, and the drive controller 110 creates a data frame including the address of a destination LED device and the control data, and transmits the created data frame to the LED device 140 via the DATA wiring. When the LED device 140-i receives the data frame, it checks the address, holds the control data when the address matches with its own address, and relays the data frame to the next LED device 140-j when the address does not match with its own address.

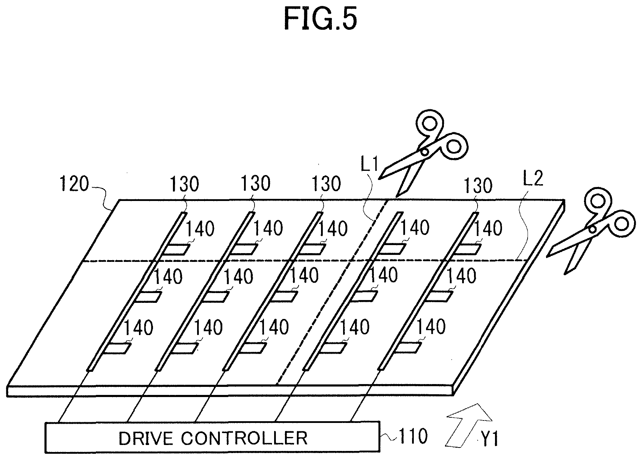

Next, a specific configuration of the display device of the present disclosure will be described. FIG. 5 is a schematic perspective view illustrating the LED substrate according to the first embodiment. The plurality of daisy-chain wirings 130 are formed on the LED substrate 120 in the column direction, and the plurality of LED devices 140 are daisy-chained through the daisy-chain wirings 130. One end of the daisy-chain wirings 130 is electrically connected to the drive controller 110, and the drive controller 110 drives each LED device 140 in a signal input direction Y1.

Since the LED device 140 is not driven by the matrix wirings, even when, for example, the LED substrate 120 is cut along a line L1 in the column direction and an unnecessary portion of the LED substrate 120 is removed, or even when the LED substrate 120 is cut along a line L2 in the row direction and an unnecessary portion of the LED substrate 120 is removed, the LED devices 140 in the remaining area still emit light. Accordingly, a display which can be cut into a desired shape can be achieved.

Thus, by arranging the plurality of daisy-chained LED devices on the substrate in a matrix, portions other than the signal input portion can be freely cut off to make the display into a desired shape and a display of the desired shape or size can be achieved. In addition, when a transparent substrate is used, a display which can be cut and then pasted onto another display medium can be achieved.

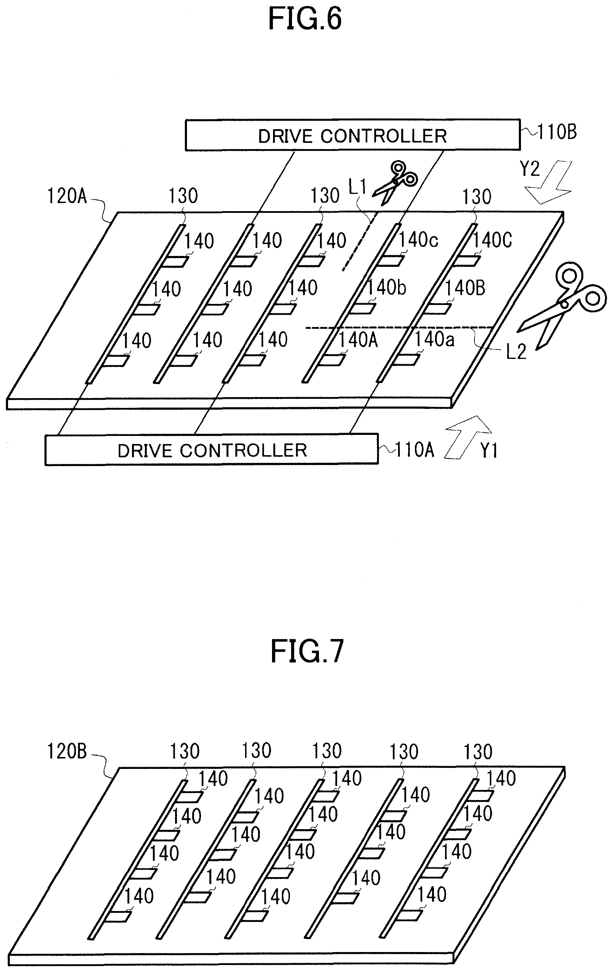

FIG. 6 is a schematic perspective view illustrating an LED substrate according to a second embodiment. An LED substrate 120A according to the second embodiment is characterized in that the signal input direction is staggered (in an alternating arrangement). That is, a drive controller 110A is arranged at one end of the LED substrate 120A in the column direction, a drive controller 110B is arranged at the other end of the LED substrate 120A, the even-numbered daisy-chain wirings 130 are electrically connected to the drive controller 110A, and the odd-numbered daisy-chain wirings 130 are electrically connected to the drive controller 110B. Y1 and Y2 indicate signal input directions with respect to the LED device 140.

For example, as illustrated in the figure, when the substrate is cut along the daisy-chain wiring 130 in the line L1 in the column direction, a non-light-emitting portion does not occur, and when the substrate is cut along the line L2 in the row direction, the LED devices 140A, 140B, and 140C beyond the cut line are not lit, but the LED devices 140a, 140b, and 140c before the cut line are lit because the signals are input by the staggered wiring. As described above, in the second embodiment, only the display resolution of the non-light-emitting portion becomes coarse, and a display function can be maintained.

FIG. 7 is a schematic perspective view illustrating an LED substrate according to a third embodiment. In the display in which a plurality of linear LED devices are arranged as in the first embodiment, an LED substrate 120B according to the third embodiment is characterized in that the LED devices 140 are arranged in an alternating pattern. As illustrated in the figure, the LED devices 140 are arranged such that a pitch of the LED devices 140 in an odd-numbered column direction is offset by 1/2 from the pitch of the LED devices 140 in an even-numbered column direction.

When a plurality of LED devices connected in a daisy chain are serially driven, the number of LED devices that can be connected may be limited due to the influence of the drive frequency of the control data by the drive controller 110. Therefore, in a large display, the pitch of the LED devices may become large and thus, a displayed image may become coarse. In the third embodiment, the LED devices 140 (pixels) are in a staggered arrangement, such that the displayed image can be displayed in high density.

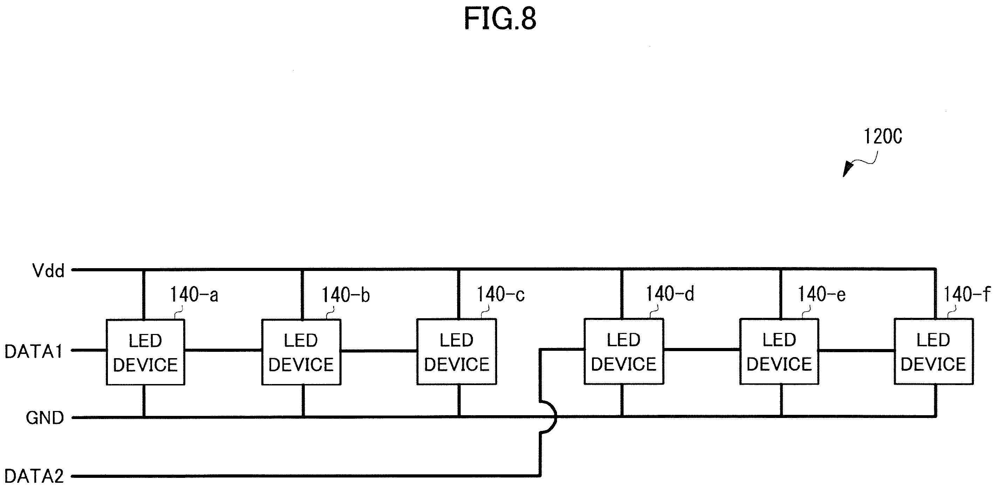

FIG. 8 is a diagram illustrating the daisy-chain wiring of an LED substrate according to a fourth embodiment. An LED substrate 120C according to the fourth embodiment is characterized in that the DATA wiring of the daisy-chain wiring is divided into a plurality of pieces. Single linear daisy-chain wiring 130 includes, for example, a wiring divided into two pieces, a DATA1 wiring and a DATA2. The DATA1 wiring is daisy-chained to a first group of LED devices 140-a, 140-b, and 140-c among the linear LED devices 140-a to 140-f, and the DATA2 wiring is daisy-chained to a second group of LED devices 140-d, 140-e, and 140-f.

Although the number of connected LED devices may be limited by the drive frequency of the control data, the number of LED devices that can be arranged on one line can be increased and the resolution of the display can be increased by dividing the DATA wiring into a plurality of pieces as in the present embodiment. In the example as illustrated in FIG. 8, the DATA wiring is divided into two, but this is not limited to this, and the DATA wiring on one line can be divided into three or more.

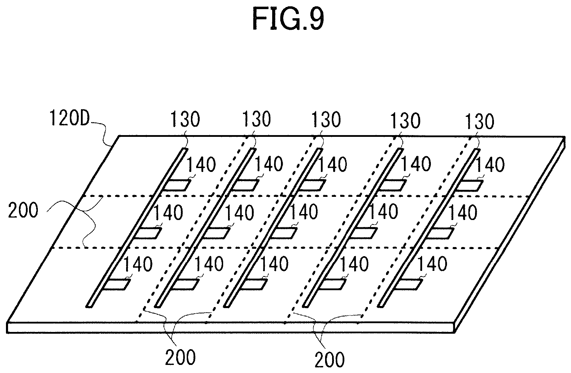

FIG. 9 is a schematic perspective view illustrating an LED substrate according to a fifth embodiment. In the display in which a plurality of linear LED devices are arranged as described in the first embodiment, an LED substrate 120D according to the fifth embodiment makes cuts in an unmounted area of the substrate (for example, film substrate) of the LED device to facilitate cutting of the display into a desired shape, as well as to avoid damage to the LED device.

As illustrated in FIG. 9, a plurality of cuts 200 (illustrated by dashed lines) are formed in the LED substrate 120D in the row direction and the column direction, for example. The cuts 200 are, for example, grooves, holes, and recesses. By forming the cuts 200, a user can readily cut the substrate along the cuts 200. Incidentally, the cuts 200 are not necessarily in a straight line, but may be in a curved line or a bent line, or may indicate a contour of a certain shape (for example, circular, rectangular, etc.).

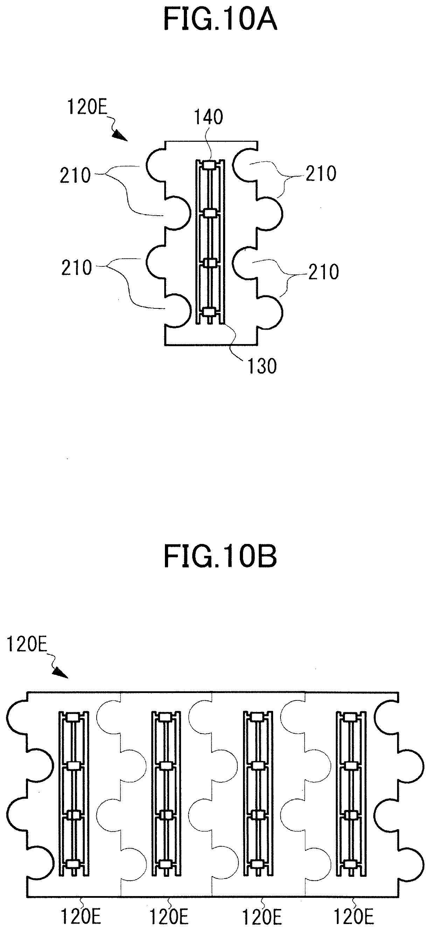

FIGS. 10A and 10B are plan views illustrating an LED substrate according to a sixth embodiment. In the sixth embodiment, the outline of an LED substrate 120E in which at least one linear LED device is arranged is shaped like a puzzle pattern, for example, such that the LED substrate 120E can be connected to or detached from other LED substrates 120E.

As illustrated in FIG. 10A, the LED substrate 120E includes at least one LED device 140 connected in the daisy chain, and puzzle patterns 210 which are semicircular irregularities formed on the left and right sides of the LED substrate 120E. Such an LED substrate 120E is considered to be one basic module, and by connecting three other LED substrates 120E as illustrated in FIG. 10B, an LED substrate of a desired size or shape can be obtained.

Here, the puzzle patterns 210 are formed only on the left and right sides of the LED substrate 120E, but it is also possible to form the puzzle patterns on upper and lower sides of the LED substrate 120E to change the size or shape of the LED substrate in a vertical direction. The shape of the puzzle patterns can be of any shape, as long as they are connectable or detachable (engageable) from other LED substrates.

Although the configurational examples of the LED substrate are described in the first to fifth embodiments, the present disclosure may include any combination of the first to fifth embodiments. For example, the LED substrate may be a combination of the second and fifth embodiments, or a combination of the third and fourth embodiments.

According to the present disclosure, since the plurality of light-emitting devices are connected in the daisy chain, generation of a non-display area can be suppressed while obtaining a desired display area as required by a user by cutting the substrate.

Although preferred embodiments of the present invention have been described in detail above, the present invention is not limited to a specific embodiment, and various modifications and changes may be made within the scope of the claims.

## Claims

1. A display device comprising:
a substrate;
a daisy-chain wiring formed on the substrate; and
a plurality of light-emitting devices connected in a daisy chain via the daisy-chain wiring.

2. The display device according to claim 1, wherein
the daisy-chain wiring includes a power supply wiring, a GND wiring, and a data wiring, which are linear, and
a plurality of daisy-chain wirings are formed on the substrate, each of the daisy-chain wirings configured as the daisy-chain wiring.

3. The display device according to claim 2, wherein
each of the light-emitting devices includes a power supply terminal, a GND terminal, a data input terminal, and a data output terminal,
in the light-emitting devices which are connected in the daisy chain, power supply terminals, each configured as the power supply terminal, are connected to the power supply wiring in common, and GND terminals, each configured as the GND terminal, are connected to the GND wiring in common, the data input terminal is connected to the data output terminal of an adjacent light-emitting device via the data wiring, and the data output terminal is connected to the data input terminal of an adjacent light-emitting device via the data wiring, and
each of the light-emitting devices controls light emission based on control data received from the data input terminal.

4. The display device according to claim 3, wherein
in the substrate on which the plurality of daisy-chain wirings are formed, the control data is supplied from one end of an even-numbered data wiring, and the control data is supplied from another end of an odd-numbered data wiring.

5. The display device according to one of claims 2 to 4, wherein
in the substrate on which the plurality of daisy-chain wirings are formed, the light-emitting devices are arranged in an alternating pattern.

6. The display device according to one of claims 2 to 5, wherein
the daisy-chain wiring includes a plurality of data wirings by dividing the data wiring, and
each of the plurality of data wirings is connected to the light-emitting devices of a corresponding group, the light-emitting devices of the corresponding group being linearly arranged.

7. The display device according to one of claims 1 to 6, wherein
cuts are formed on the substrate to facilitate cutting of the substrate.

8. The display device according to one of claims 1 to 7, wherein
at least on one side of the substrate, a pattern engageable with a pattern on another side of another substrate is formed.

9. The display device according to one of claims 1 to 8, wherein
the substrate is a transparent film substrate.
